# NEUE EUROPÄISCHE PATENTSCHRIFT

(11) **EP 1 006 766 B2**
(45) Veröffentlichungstag und Bekanntmachung des Hinweises auf die Entscheidung über den Einspruch: **26.08.2009**
(45) Hinweis auf die Patenterteilung: 30.07.2003
(21) Anmeldenummer: 99123082.2
(22) Anmeldetag: 22.11.1999
(51) Int. Cl.: H05K 5/00, H05K 7/20

(54) **Elektronische Vorrichtung**
Electronic device
Dispositif électronique

(30) Priorität: 01.12.1998 DE 19855389
(43) Veröffentlichungstag der Anmeldung: 07.06.2000
(73) Patentinhaber: Continental Automotive GmbH, 30165 Hannover (DE)
(72) Erfinder: Krohn, Thomas, 65824 Schwalbach (DE); Ullrich, Horst, 61137 Schöneck (DE)

(56) Entgegenhaltungen:
- EP-A- 0 641 154
- EP-A- 0 682 467
- EP-A- 0 827 373
- EP-A2- 0 854 667
- DE-A- 4 224 720
- DE-A1- 3 936 906
- DE-A1- 4 305 793
- DE-A1- 4 329 083
- DE-C- 4 142 138
- DE-C2- 3 624 845
- DE-C2- 3 916 899
- US-A- 4 471 407

## Beschreibung

Die Erfindung betrifft eine Vorrichtung nach dem Oberbegriff des Anspruchs 1.

In Kraftfahrzeugen werden elektrische Steuergeräte eingesetzt, welche Leistungselektroniken beinhalten, die hohe Verlustleistungen erzeugen. Solche Verlustleistungen werden normalerweise über das Metallgehäuse des Steuergerätes an die Umgebung abgeführt. Da diese Gehäuse der Steuergeräte zweiteilig ausgebildet sind, ist zur Verhinderung des Eindringens von Feuchtigkeit in das Gehäuse eine Abdichtung der elektrischen Anschlüsse sowie des gesamten Gehäuses notwendig. Dies ist besonders problematisch und teuer, da zusätzliche Dichtungen und Befestigungselemente notwendig sind, die weitere Montageschritte und Prüfverfahren nach sich ziehen.

Aus der DE 41 42 138 C2 ist ein elektrisches Steuergerät bekannt, welches ein zweiteiliges Gehäuse aufweist, wobei die, die Elektronik tragende Leiterplatte auf einer Aluminiumgrundplatte des Steuergerätes angeordnet ist, über welcher ein zweites, aus Kunststoff bestehendes Gehäuseteil mit einem integrierten Stecker angeordnet ist. Das Kunststoffgehäuse weist dabei eine Öffnung auf, welche erst nach elektrischer Verbindung der Steckerpins mit der auf der Leiterplatte angeordneten Elektronik abgedeckt wird. Diese Öffnung macht zusätzliche Schutzmaßnahmen notwendig, um ein Eindringen von Feuchtigkeit in das Steuergerät zu verhindern.

Der Erfindung liegt somit die Aufgabe zugrunde, eine elektronische Vorrichtung anzugeben, welche die elektronische Schaltung zuverlässig gegen Feuchtigkeit schützt.

Erfindungsgemäß wird die Aufgabe durch die Merkmale des Anspruchs 1 gelöst.

Der Vorteil der Erfindung besteht darin, daß zum Zwecke der Wärmeabfuhr auf ein Metallgehäuse vollständig verzichtet werden kann. Das Kunststoffgehäuse ist wesentlich kostengünstiger in nur einem einzigen Spritzgußvorgang herstellbar. Eine Nacharbeit bei einem so erzeugten Gehäuseteil kann vollständig entfallen. Durch die Umspritzung des metallischen Kühlkörpers mit dem Kunststoff werden Nahtstellen auf ein Minimum reduziert. Isolationsdichtungen, welche das Eindringen von Feuchtigkeit verhindern sollen, entfallen.

Vorteilhafterweise weist die metallische Wärmeleiteinrichtung eine, über die Außenfläche des ersten Gehäuseteiles hinausragende, rippenähnliche Struktur auf. Aufgrund dieser Kühlkörperausbildung, kann die Wärmeabgabe an die Umwelt des Steuergerätes entsprechend der im konkreten Fall anfallenden Verlustwärme optimal gestaltet werden, da die Auswahl des Kühlkörpers in Abhängigkeit der anfallenden Verlustwärme erfolgt.

Um die Wärmeableitung von der Elektronik auf die Wärmeleiteinrichtung gezielt zu ermöglichen, liegt mindestens ein Teil des Trägersubstrates unmittelbar auf der in das Gehäuseinnere weisenden Seite der Wärmeleiteinrichtung auf.

Dabei wird der Wärmeübergang vom Trägersubstrat an die Wärmeleiteinrichtung entweder durch eine elektrisch isolierte Schraubverbindung oder durch ein Wärmeleitmedium unterstützt, welches das Trägersubstrat mit der Wärmeleiteinrichtung verklebt.

In einer Ausgestaltung sind auf der, der Wärmeleiteinrichtung abgewandten Oberfläche des Trägersubstrates Leistungsbauelemente oberflächenmontiert. Dabei werden die Leistungsbauelemente in dem Bereich des Trägersubstrates angeordnet, welcher direkt auf der Wärmeleiteinrichtung aufliegt. Durch diese Maßnahme ist eine gezielte Wärmeabfuhr vom Leistungsbauelement an den Kühlkörper möglich, ohne andere Teile der elektronischen Schaltung durch die Verlustwärme zu beeinflussen.

Bei der Oberflächenmontage der Leistungsbauelemente ist eine gleichzeitige Verlötung der Steckerstifte, welche mit der Leiterplatte verbunden sind, in einem Arbeitsgang möglich.

Vorteilhafterweise ist ein zweites, aus Kunststoff bestehendes Gehäuseteil als Abdeckung ausgebildet, welches in das erste Gehäuseteil einklipsbar ist. Mit Hilfe dieser Ausgestaltung kann nach dem Verlöten der Bauteile innerhalb des ersten Gehäuseteiles das Gehäuse durch einen einfachen Arbeitsgang abgeschlossen werden.

In einer Weiterbildung sind die an den Trägersubstrat befestigten und mit der elektronischen Schaltung elektrisch verbundenen Steckerpins durch das erste Gehäuseteil hindurch nach außen in den Steckerkörper geführt.

Die Erfindung läßt zahlreiche Ausführungsformen zu. Eine davon soll anhand der in der Zeichnung dargestellten Figuren näher erläutert werden.

Es zeigt:
- Figur 1:: Schnitt durch ein erfindungsgemäßes Steuergerät.
- Figur 2:: Explosionsdarstellung des erfindungsgemäßen Steuergerätes .

Gleiche Merkmale sind mit gleichen Bezugszeichen gekennzeichnet.

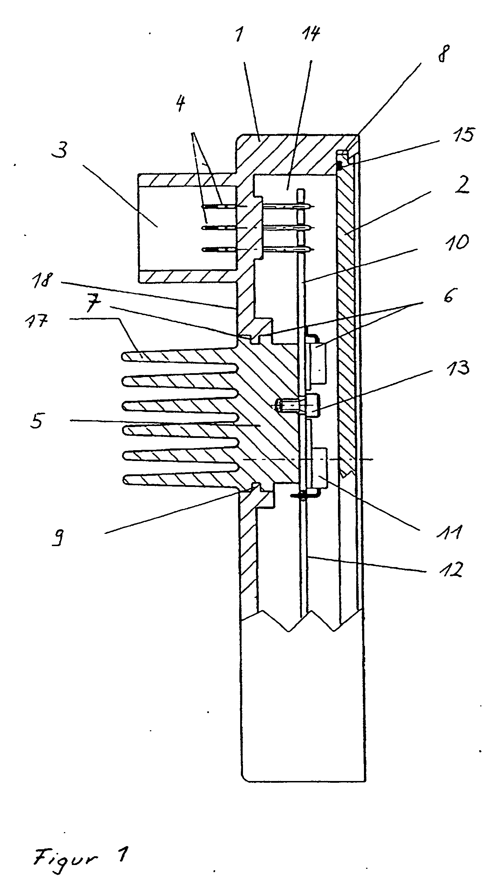

In Figur 1 ist ein elektrisches Steuergerät, wie es in Kraftfahrzeugen Anwendung findet, dargestellt. Es besitzt ein aus Kunststoff bestehendes becherförmiges Gehäuseteil 1, welches mit einer ebenfalls aus Kunststoff bestehenden Abdeckung 2 verschlossen ist. Das becherförmige Gehäuseteil 1 besitzt einen einstückig mit dem Gehäuseteil verbundenen Steckerkörper 3, wobei die Steckerpins 4 sowohl in den Steckerkörper 3 als auch in das Gehäuseinnere 14 weisen.

Ein metallischer Kühlkörper 5 ist in das Gehäuseteil 1 eingelassen. Vorteilhafterweise werden bei der Herstellung des Gehäuseteiles 1 der Kühlkörper 5 und die Steckerpins 4 in eine Spritzgußgehäuseform eingelegt und in einem einzigen Spritzgußvorgang mit Kunststoff umspritzt. Zur sicheren Befestigung des Kühlkörpers 5 weist dieser an seinen dem Spritzgußgehäuse zugewandten Seiten 6 jeweils eine Nut 7 auf, in welche nach der Umspritzung mit Kunststoff jeweils ein Kunststoffvorsprung 9 eingreift. Dies ermöglicht eine sichere Befestigung des Kühlkörpers 5 am Gehäuseteil 1 und dient zusätzlich der Abdichtung der Verbindungsstelle zwischen Gehäuseteil 1 und dem Kühlkörper 5.

Der Kühlkörper 5 weist Kühlrippen 17 auf, welche über die Außenfläche 18 des becherförmigen Gehäuseteiles 1 hinausragen.

Im Gehäuseinneren 14 ist auf dem Kühlkörper 5 eine Leiterplatte 10 angeordnet, welche Leistungsbauelemente 11 trägt. Die Leistungsbauelemente 11 sind auf der dem Kühlkörper 5 abgewandten Oberfläche 12 der Leiterplatte 10 angeordnet. Sie liegen in dem Bereich, in welchem die Leiterplatte 10 den Kühlkörper 5 flächig berührt, was eine gezielte Wärmeabfuhr ermöglicht. Im vorliegenden Beispiel wird die Wärmeübergangszone durch eine Schraube 13 realisiert. Die Schraube 13 ist dabei elektrisch isoliert. Die in das Gehäuseinnere 14 hineinragenden Steckerpins 3 sind elektrisch mit den auf der Leiterplatte 10 befindlichen Leistungsbauelementen 11 verbunden.

Das erste Gehäuseteil 1 ist mit dem Kunststoffdeckel 2 abgedeckt. Dabei wird der Kunststoffdeckel 2 in das erste Gehäuseteil 1 eingeklipst.

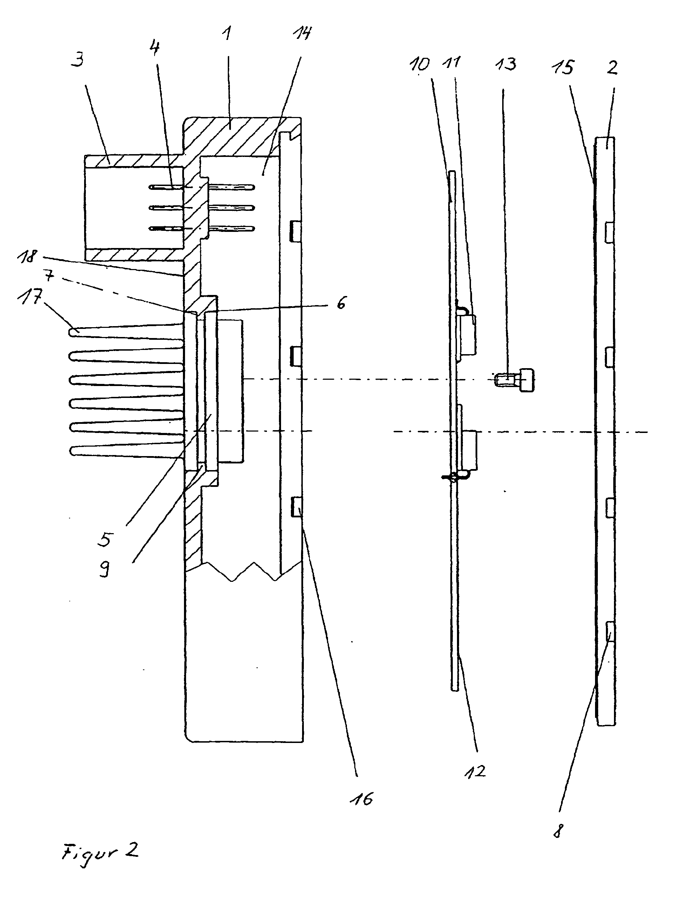

Wie aus Figur 2 hervorgeht, weist die Abdeckung 2 eine Dichtung 15 auf, die an dieser integriert ist. Diese Dichtung 15 besteht aus einer weichplastischen Kunststoffschicht, welche in einem Schweißprozeß an der hardplastischen Abdeckung 2 befestigt wird. Die Dichtung ist sehr flexibel und dichtet die Nahtstellen zwischen dem ersten Gehäuseteil 1 und der Abdeckung 2 zuverlässig ab.

Die Abdeckung 2 weist entlang ihres Umfanges in annähernd gleichen Abständen Vorsprünge 8 auf, welche in entsprechende Ausnehmungen 16 am Gehäuseteil 1 eingreifen.

Das erfindungsgemäße Steuergerät ist einfach herstellbar, in hohem Maße wasserdicht und genügt großen mechanischen Beanspruchungen.

### Bezugszeichen

- 1: becherförmiges Gehäuseteil
- 2: Abdeckung
- 3: Steckerkörper
- 4: Steckerpins
- 5: Kühlkörper
- 6: Dem becherförmigen Gehäuseteil zugewandte Seite des Kühlkörpers
- 7: Nut
- 8: Vorsprung der Abdeckung
- 9: Vorsprung des ersten Gehäuseteiles
- 10: Leiterplatte
- 11: Leistungsbauelemente
- 12: Oberfläche der Leiterplatte
- 13: Schraube
- 14: Gehäuseinneres
- 15: Dichtung
- 16: Ausnehmung
- 17: Rippen des Kühlkörpers
- 18: Außenfläche des becherförmigen Gehäuseteiles

## Patentansprüche

1. Vorrichtung mit einem zweiteiligen Gehäuse zur Aufnahme eines, eine elektronische Schaltung tragenden Trägersubstrates, wobei ein aus einem Kunststoff bestehendes erstes Gehäuseteil einen integrierten, aus Kunststoff ausgebildeten Steckerkörper aufweist und wobei eine metallische Wärmeleiteinrichtung an dem ersten Gehäuseteil angeordnet ist, auf deren in das Gehäuseinnere weisenden Seite das die elektronische Schaltung tragende Trägersubstrat befestigt ist, **dadurch gekennzeichnet, dass** zur Herstellung des ersten Gehäuseteils (1) die metallische Wärmeleiteinrichtung (5) und Steckpins (4) in einem einzigen Spritzgussvorgang mit Kunststoff umspritzt sind.

2. Vorrichtung nach Anspruch 1 **dadurch gekennzeichnet, daß** die metallische Wärmeleiteinrichtung (5) eine über die Außenfläche (18) des ersten Gehäuseteiles (1) hinausragende rippenähnliche Struktur (17) aufweist.

3. Vorrichtung nach Anspruch 1 **dadurch gekennzeichnet, daß** mindestens ein Teil des Trägersubstrates (10) unmittelbar auf der in das Gehäuseinnere (14) hineinragenden Seite der Wärmeleiteinrichtung (5) flächig aufliegt.

4. Vorrichtung nach Anspruch 3 **dadurch gekennzeichnet, daß** das Trägersubstrat (10) mit Hilfe einer elektrisch isolierten Schraubverbindung (13) an der Wärmeleiteinrichtung (5) befestigt ist.

5. Vorrichtung nach Anspruch 3 **dadurch gekennzeichnet, daß** das Trägersubstrat (10) mit Hilfe eines Wärmeleitmediums mit der Wärmeleiteinrichtung (5) verklebt ist.

6. Vorrichtung nach Anspruch 3, 4 oder 5 **dadurch gekennzeichnet, daß** auf der, der Wärmeleiteinrichtung (5) abgewandten Oberfläche (12) des Trägersubstrates (10) Leistungsbauelemente (11) oberflächenmontiert sind.

7. Vorrichtung nach Anspruch 1 **dadurch gekennzeichnet, daß** ein zweites, aus Kunststoff ausgebildetes Gehäuseteil (2) als Abdeckung ausgebildet ist, welches in das erste Gehäuseteil (1) einklipsbar ist.

8. Vorrichtung nach Anspruch 1, **dadurch gekennzeichnet, daß** an dem Trägersubstrat (10) befestigte und mit der elektronischen Schaltung (11) elektrisch verbundene Steckerpins (4) durch das erste Gehäuseteil (1) hindurch nach außen in den Steckerkörper (3) ragen.

## Claims

1. Device with a two-part housing for receiving a carrier substrate, which carries an electronic circuit, a first housing part, consisting of plastic, having an integrated connector body formed from plastic, a metallic heat conducting means, on the side of which facing into the interior of the housing the carrier substrate carrying the electronic circuit is attached, being arranged on the first housing part **characterized in that**, for the production of the first housing part (1), the metallic heat conducting means (5) and the connector pins (4) are encapsulated in plastic in a single injection-moulding operation.

2. Device according to Claim 1, **characterized in that** the metallic heat conducting means (5) has a rib-like structure (17) protruding beyond the outer surface (18) of the first housing part (1).

3. Device according to Claim 1, **characterized in that** at least part of the carrier substrate (10) lies in surface-area contact directly on the side of the heat conducting means (5) protruding into the interior (14) of the housing.

4. Device according to Claim 3, **characterized in that** the carrier substrate (10) is attached to the heat conducting means (5) with the aid of an electrically insulated screw connection (13).

5. Device according to Claim 3, **characterized in that** the carrier substrate (10) is adhesively bonded to the heat conducting means (5) with the aid of a heat conducting medium.

6. Device according to Claim 3, 4 or 5, **characterized in that** power components (11) are surface-mounted on the surface (12) of the carrier substrate (10) facing away from the heat conducting means (5).

7. Device according to Claim 1, **characterized in that** a second housing part (2), formed from plastic, is formed as a covering, which can be clipped into the first housing part (1).

8. Device according to Claim 1, **characterized in that** connector pins (4) attached to the carrier substrate (10) and electrically connected to the electronic circuit (11) protrude out through the first housing part (1) into the connector body (3).

## Revendications

1. Dispositif comportant un boîtier en deux parties pour recevoir un substrat porteur portant un circuit électronique, dans lequel une première partie de boîtier réalisée en matière plastique présente un premier corps de fiche intégré réalisé en matière plastique et dans lequel un dispositif métallique de transmission de chaleur est disposé sur la première partie de boîtier, sur le côté de laquelle, tourné vers le volume intérieur de boîtier, est fixé le substrat porteur portant le circuit électronique, **caractérisé en ce que**, pour fabriquer la première partie de boîtier (1), le dispositif métallique de transmission de chaleur (5) et les broches d'enfichage (4) sont enrobés de matière plastique par extrusion dans une unique opération de moulage par injection.

2. Dispositif suivant la revendication 1, **caractérisé en ce que** le dispositif métallique de transmission de chaleur (5) présente une structure (17) en forme d'ailettes en saillie de la surface extérieure (18) de la première partie de boîtier (1).

3. Dispositif suivant la revendication 1, **caractérisé en ce qu'**au moins une partie du substrat porteur (10) repose par sa surface directement sur la face du dispositif de transmission de chaleur (5), pénétrant dans le volume intérieur (14) du boîtier.

4. Dispositif suivant la revendication 3, **caractérisé en ce que** le substrat porteur (10) est fixé sur le dispositif de transmission de chaleur (5) à l'aide d'une liaison à vis (13) isolée électriquement.

5. Dispositif suivant la revendication 3, **caractérisé en ce que** le substrat porteur (10) adhère au dispositif de transmission de chaleur (5) au moyen d'un milieu conducteur de la chaleur.

6. Dispositif suivant la revendication 3, 4 ou 5, **caractérisé en ce que** des composants de puissance (11) sont montés en surface sur la surface (12) du substrat porteur (10), située à l'opposée du dispositif de transmission de chaleur (5).

7. Dispositif suivant la revendication 1, **caractérisé en ce qu'**une seconde partie de boîtier (2), réalisée en matière plastique, se présente sous la forme d'un couvercle, ladite seconde partie de boîtier (2) pouvant être enclenchée dans la première partie de boîtier (1).

8. Dispositif selon la revendication 1, **caractérisé en ce que** des broches (4) liées au substrat porteur (10) et connectées électriquement au circuit électronique (11) font saillie à travers la première partie de boîtier vers l'extérieur dans le corps de conversion (3).
